(19) Europäisches Patentamt

European Patent Office

Office européen des brevets

(11) **EP 2 610 913 A1**

(12) **EUROPEAN PATENT APPLICATION**

(43) Date of publication:
**03.07.2013 Bulletin 2013/27**

(51) Int Cl.:
**H01L 29/66** (2006.01)  **H01L 43/06** (2006.01)

(21) Application number: **11196194.2**

(22) Date of filing: **30.12.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Hitachi Ltd.**
**Tokyo (JP)**

(72) Inventors:
• **Wunderlich, Joerg**
  **Cambridge Cambridgeshire CB3 0HE (GB)**

• **Olejnik, Kamil**
  **Cambridge Cambridgeshire CB3 0HE (GB)**
• **Jungwirth, Tomas**
  **162 53 Praha 6 (CZ)**
• **Sinova, Jairo**
  **162 53 Praha 6 (CZ)**

(74) Representative: **Piotrowicz, Pawel Jan Andrzej et al**
**Venner Shipley LLP**
**Byron House**
**Cambridge Business Park**
**Cowley Road**
**Cambridge CB4 0WZ (GB)**

(54) **Spin-based device**

(57) A spin-based device (1) comprises a channel (4), first and second electrodes (23, 24) configured, in response to a bias configuration, to generate an electric field along the channel, and a spin injector (17) arranged to inject spin into the channel at a point between the first and second electrodes. The device may further comprise a spin current detector (9) and/or a spin accumulation detector (18) arranged at different points(s) along the channel.

Fig. 1

EP 2 610 913 A1

**Description**

The present invention relates to a spin-based device.

Current field effect transistor technology used in logic and memory is approaching its scaling limit. Power consumption and operating speed are not being reduced as transistors are scaled down in size. Thus, alternative technologies are being investigated which address these problems, such as power dissipation.

One promising technology is based on the generation, manipulation and detection of spin and spin currents. Reference is made to S. Datta and B. Das: "Electronic analog of the electrooptic modulator", Applied Physics Letters, volume 56, 665-667 (1990).

Reference is made to EP 2 190 022 A which describes injection of spin-polarised charge carriers into an end of a channel.

However, one drawback of such devices is that spin current is not amplified.

B. Huang, D. Monsma and I. Appelbaum: "Experimental realization of a silicon spin field-effect transistor" Applied Physics Letters, volume 91, 072501 (2007) describes using a longitudinal electric field to control transit time through an undoped vertical channel of spin-polarized electrons precessing in a perpendicular magnetic field.

However, this device suffers a number of drawbacks. In particular, the magnetocurrent is modulated mainly through injection conditions. Furthermore, the device is fabricated using a complex wafer bonding process.

According to a first aspect of the present invention there is provided a spin-based device comprising a channel, first and second electrodes configured, in response to a bias configuration, to generate an electric field along the channel, a spin injector configured to inject a spin-polarised current into the channel at a point between the first and second electrodes.

Thus, an electric field, which can be controlled independently of the injection current, can be used to alter the drift velocity of spin-polarised charge carriers. This can be used to change spin current and/or spin accumulation in the channel.

The first and/or second electrode(s) may comprise a non-magnetic material, such as gold. The first and/or second electrode(s) may comprise a magnetic material, such as iron. If the first and/or second electrode(s) comprise magnetic material, the electrode(s) can be positioned sufficiently far away that the current from the first and second electrodes is no longer spin polarised at the spin injector and/or a point of detection, i.e. the separation, L, between the first and second electrodes is such that $L/2 \gg v_F \times \tau_S$ where $v_F$ is the velocity of charger carriers at the Fermi level and $\tau_S$ is the spin relaxation time. However, if the first and/or second electrode(s) comprise magnetic material, then the first and/or second electrode(s) can be positioned closer, i.e. such that $L/2 \leq v_F \times \tau_S$, in which case the spin-polarised current injected by first and/or second electrode(s) is non-zero at the spin injector and/or point of detection.

For a semiconductor channel, the current density in the channel preferably does not exceed $10^6$ Acm$^{-2}$. For a metal channel, the current density in the channel preferably does not exceed $10^9$ Acm$^{-2}$.

The device may comprise a spin current detector configured to detect a spin current at a second, different position between the first and second electrodes. The spin current detector may include at least one Hall probe disposed between the spin injector and the first or second electrodes. The spin current detector may include a magnetic field source arranged to apply a magnetic field to the channel.

The device may comprise a spin accumulation detector configured to detect spin accumulation at a third position between the first and second electrodes. The third position may the same as or different from the second position. The spin detector may comprise a ferromagnetic electrode disposed between the spin injector and the first or second electrode. The device may comprise a voltmeter arranged to measure a bias between the ferromagnetic electrode and the first or second electrode.

The spin injector may comprise a ferromagnetic electrode. The ferromagnetic electrode may comprise iron, nickel and/or cobalt. The ferromagnetic electrode may comprise a Heusler alloy having, for example, a formula X$_2$YZ. The Heusler alloy may comprise Co$_2$FeZ, where Z = Al, Ga, Si or Ge. The spin injector may comprise more than one ferromagnetic electrode.

The spin injector may comprise a light source directed at the channel between the first and second electrodes.

The spin injector may comprise a ferromagnetic region in contact with the channel for injecting spin into the channel using spin pumping. The spin injector may further comprise a source for generating a radio frequency current in the ferromagnetic region. The source may comprise a current source for driving the current in the ferromagnetic region. The source may comprise a microwave source for inducing the current in the ferromagnetic region. The magnetic field generated by the microwave source at the ferromagnetic region may directly excite ferromagnetic resonance in the ferromagnetic region to pump spin into the channel.

The spin injector may comprise a ferromagnetic region in contact with the channel for injecting spin into the channel using the spin Seebeck effect. The spin injector may comprise a heater for generating a temperature gradient between the ferromagnetic region and the channel. The heater may include a voltage or current source for driving a current through a wire for Joule heating the ferromagnetic region. The wire may be integrally formed in the ferromagnetic region. For example, the ferromagnetic region may include a constriction for increasing electrical resistance. Additionally or alternatively, the material forming the ferromagnetic region may exhibit a suitably high electrical resistivity and thus Joule heating can occur in the ferromagnetic region. The source may be arranged to drive a current through the ferromagnetic region.

The channel may be formed from a material which exhibits no magnetic order. The channel may be formed from a material which is not magnetic, for example, a material which is neither ferromagnetic nor antiferromagnetic.

The channel may be formed of a semiconductor material, such as gallium arsenide. The semiconductor channel may be doped with acceptors or donors to an average concentration of no more than $1 \times 10^{18}$ cm$^{-3}$. The semiconductor channel may comprise a two-dimensional electron gas (2DEG) or two-dimensional hole gas (2DHG).

The channel may comprise a metallic material. The channel may comprise copper, aluminium, silver or other material which exhibits a long spin-decoherence length so that the length is of the same order or greater than the distance between the spin injector and the spin detector.

The channel may be provided in a layer and the first and second electrodes may be provided on, under, to the side of and/or at the end of the channel and spin can be injected between the electrodes, for example, by providing an electrode on, under or to the side of the channel in between the electrodes. Thus, the device can be easily fabricated, for example, by etching the layer to form a (lateral) channel and the channel can be easily accessed (e.g. be contacted) using the electrodes and spin injector.

According to a second aspect of the present invention there is provided apparatus comprising the spin-based device and a bias source configured to apply a bias between the first and second electrodes.

The apparatus may further comprise a bias source configured to cause the spin injector to generate spin-polarization in the channel (i.e. the spin injector generates or causes electrical spin injection). The spin injector may cause spin polarization in the channel by directly injecting spin-polarised electrons into the channel. The spin injector may cause spin polarization in the channel by spin-selectively collecting spin-polarised electrons in case of opposite bias current polarity.

According to a third aspect of the present invention there is provided a method of operating a spin-based device comprising generating an electric field along a channel and injecting spin into the channel.

The method may further comprise detecting spin current in the channel. Detecting spin current may comprise applying a magnetic field. The magnetic field can be applied such that a component of the magnetic field is perpendicular to the orientation of the polarization of the injected spin. For example, the magnetic field can be applied perpendicular to the channel if spin is injected which is aligned along the channel. Alternatively, the magnetic field can be applied along the channel if spin is injected which is aligned perpendicular to the channel.

The method may further comprise detecting spin accumulation in the channel.

Generating the electric field may comprise applying a bias between first and second electrodes spaced apart along the channel.

According to a fourth aspect of the present invention there is provided a spin-based device comprising a channel, first and second electrodes configured, in response to a bias configuration, to generate an electric field along the channel, a spin injector configured to inject a spin-polarised current into the channel at a point between the first and second electrodes, wherein the channel is configured to carry substantially only one type of charge carrier (such as electrons) between the first and second electrodes.

Certain embodiments of the present invention will now be described, by way of example, with reference to the accompanying drawings, in which:

Figure 1 is a perspective view of a device in accordance with the present invention;
Figure 2 illustrates operation of the device shown in Figure 1;
Figures 3a illustrates plots of measured non local spin valve voltage, $V_{NL}$, against magnetic field, $B_x$, at three different drift current biases, $I_D$, measured at 4.2 K;
Figure 3b illustrates plots of measured spin Hall voltage, $V_H$, against magnetic field , $B_x$, at three different drift current biases, $I_D$, measured at 4.2 K;
Figure 3c illustrate plots of modelled non local spin valve voltage, $V_{NL}$, against magnetic field, $B_x$, at three different drift current biases, $I_D$;
Figure 3d illustrates plots of modelled spin Hall voltage, $V_H$, against magnetic field, $B_x$, at three different drift current biases, $I_D$;
Figure 4 illustrates spin polarization profile $P_y(x) = S_y(x)/n$ obtained by solving drift-diffusion equations using the parameters of the device shown in Figure 1;
Figure 5a is calculated Hall cross response in the x-y plane for the geometry of the device shown in Figure 1;
Figure 5b is a calculated Hall cross response function averaged over the channel width;

Figure 5c illustrates spin-current profile $j_z^s(x)$ obtained by solving drift-diffusion equations for the parameters obtained from Figures 3a and 3b;
Figure 6 illustrates a layer structure grown by molecular beam epitaxy from which the device shown in Figure 1 is fabricated; and
Figure 7 is a process flow diagram of a method of fabricating the device shown in
Figure 1.

*Device structure*

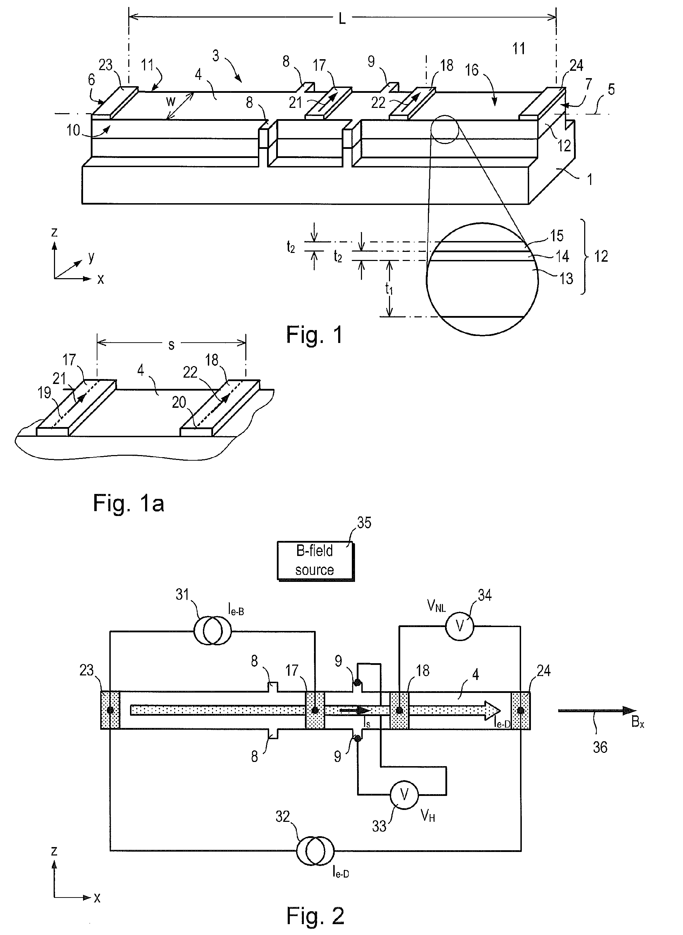

Referring to Figure 1, a spin-based device 1 in accordance with the present invention is shown. The device 1 includes a substrate 2 formed of undoped gallium arsenide (GaAs) which supports a Hall bar 3. The Hall bar 3 includes an elongate channel 4, orientated along an axis 5 (in this case, the x-axis) between first and second ends 6, 7. The Hall bar 3 includes first and second pairs of laterally-arranged Hall probes 8, 9. As shown in Figure 1, each pair of Hall probes 8, 9 are arranged on opposite sides 10, 11 of the channel 4 and can be used to measure a Hall voltage, $V_H$, arising from an inverse spin-Hall effect (iSHE). The first and second pair of Hall probes 8, 9 are spaced apart along the Hall bar 3 by a separation, 1, of about 4 $\mu$m. The channel 4 and the Hall probes 8, 9 comprise the same material which, in this example, is gallium arsenide.

The Hall bar 3 includes a multilayer stack 12 including a layer 13 of lightly-doped, n-type gallium arsenide (GaAs). The gallium arsenide layer 13 is doped with silicon (Si) to a concentration of $5\times10^{16}$ cm$^{-3}$. The gallium arsenide layer 13 is has a thickness, $t_1$, of 250 nm. The gallium arsenide layer 13 is thickest layer within the stack 12.

The multilayer stack 12 also includes a layer 14 of graded-doped, n-type gallium arsenide directly disposed on the lightly-doped gallium arsenide layer 13 and a layer 15 of highly-doped, n-type gallium arsenide directly disposed on the graded-doped gallium arsenide layer 14. The graded-doped gallium arsenide layer 14 is doped with silicon (Si) with a concentration of $5\times10^{16}$ cm$^{-3}$ at the interface with the lightly-doped gallium arsenide layer 13 and a concentration of $5\times10^{18}$ cm$^{-3}$ at the interface with the heavily-doped gallium arsenide layer 15. The graded-doped gallium arsenide layer 14 is has a thickness, $t_2$, of 15 nm. The heavily-doped gallium arsenide layer 15 is also doped with silicon (Si) to a concentration of $5\times10^{18}$ cm$^{-3}$. The heavily-doped gallium arsenide layer 15 is has a thickness, $t_3$, of 15 nm. The more heavily doped layers 14, 15 are intended primarily to control (e.g. to reduce) the thickness of Schottky barriers formed between the channel 4 and surface electrodes. The multilayer stack 12 (and, thus, the Hall bar 3) has an upper surface 16 which is furthest from the substrate 2.

At least one ferromagnetic electrode 17, 18 may be disposed directly on the upper surface 16 of the multilayer stack 12. In this case, two ferromagnetic electrodes 17, 18 are provided and are spaced apart along the Hall bar 3 by a separation, s, of about of about 4 $\mu$m. As shown in Figure 1, the first ferromagnetic electrode 17 is equidistantly positioned between the first and second pairs of Hall probes 8, 9. The first and second ferromagnetic electrodes 17, 18 have respective first and second easy axes 19, 20 arranged transversely to the Hall bar. Respective first and second magnetisations 21, 22 of the first and second ferromagnetic electrodes 17, 18 can be aligned stably parallel or anti-parallel to the easy axes 19, 20. The easy axes 19, 20 are arranged perpendicularly to the axis 5 of the channel 4. However, the easy axes 19, 20 can be arranged parallel to, i.e. along, the axis 5 of the channel 4.

The ferromagnetic electrodes 17, 18 each comprise a thin layer of iron. Each ferromagnetic electrode 17, 18 has a thickness, $t_4$, of 2 nm.

Layers of gallium arsenide and iron used to form the Hall bar and ferromagnetic electrodes are grown epitaxially in a molecular beam epitaxy chamber under ultra high vacuum conditions without breaking the vacuum during growth. Thus, the thin layer iron takes the form of epitaxial, cubic iron.

The magnetic anisotropy of the ferromagnetic electrode 17, 18 has two components. One is the conventional thin-film shape anisotropy which makes the perpendicular-to-plane direction a hard magnetic axis with a corresponding anisotropy field of 2 T. Another component is an additional uniaxial magnetocrystalline anisotropy, originating from the broken [-110]/[110] symmetry of the Fe/GaAs interface which dominates the cubic magnetocrystalline anisotropy of bulk iron. This makes [-110] in-plane crystal direction (y-axis) the easy magnetic axis with a corresponding anisotropy field of 200 mT.

As will be described in more detail later, the first ferromagnetic electrode 17 (or second ferromagnetic electrode 18) is used to inject a spin-polarised current, $I_B$, into the channel 4 between first and second outer electrodes 23, 24. However, other forms of spin injector, e.g. a light source, can be used to inject spin-polarised current into the channel 4 between the first and second outer electrodes 23, 24. Thus, the first ferromagnetic electrode 17 can be omitted or modified. As will also be described in more detail later, the second ferromagnetic electrode 18 can be used to detect spin accumulation. However, if detection of spin accumulation is not required, then the second ferromagnetic electrode 18 may be omitted. Thus, in some embodiments, ferromagnetic electrodes can be omitted entirely.

The channel 4 is substantially uniform, for example, in terms of layer structure and composition (including doping type) and, optionally, configuration, along its length between the first and second electrodes 23, 24. In particular, the path through the layer structure does not include a p-n junction formed, for example, by co-planar regions of different conductivity type (i.e. n-type and p-type) and/or by different layers of different conductivity type, thereby creating a substantial region of space charge along the path. Thus, the channel 4 is configured to carry substantially only one type of charge carrier (in this case, electrons) between the first and second electrodes 23, 24. The channel 4 lies substantially in the same plane along its length between the between the first and second electrodes 23, 24.

First and second outer electrodes 23, 24 are disposed directly on the upper surface 16 of the multilayer stack 12.

The electrodes 23, 24 are preferably non-ferromagnetic. However, one or both electrodes 23, 24 can be ferromagnetic. If one or both of the outer electrode 23, 24 is (are) ferromagnetic and inject their own spin-polarised current and if this spin-polarised current is unwanted, then they can be placed sufficiently far away from the ferromagnetic electrodes 17, 18 that any spin-polarised current injected by them has relaxed by the time it reaches the Hall probes (or other spin current detector) and/or ferromagnetic electrode 17, 18 (or other spin accumulation detector). Thus, assuming that the spin injector and detectors are placed approximately midway between the first and second electrodes 23, 24, the separation, L, between first and second electrodes 23, 24 formed from magnetic material can be chosen such that $L/2 \gg v_F \times \tau_S$ where $v_F$ is the velocity of charge carriers at the Fermi level and $\tau_S$ is the spin lifetime (also referred to as the "spin relaxation time"). However, in some embodiments, $L/2 \leq v_F \times \tau_S$.

The Hall probe(s) 8, 9, the ferromagnetic electrode(s) 17, 18 and the outer electrodes 23, 24 are positioned along the channel 4 such that the Hall probe(s) 8, 9 and the ferromagnetic electrode(s) 17, 18 lie between the outer electrodes 23, 24. Thus, a spin-polarised current is injected into the channel 4 in between the outer electrodes 23, 24, i.e. between and separate from the outer electrodes 23, 24.

The outer electrodes 23, 24 each comprise a layer of gold (Au). The first and second electrodes 23, 24 are spaced apart along the Hall bar 3 by a separation, L, of about 200 $\mu$m.

Spin in the channel 4 has a spin lifetime, $\tau_S$, which is sufficiently long that spin injected by the first ferromagnetic electrode 17 reaches the detectors. Typically, the spin lifetime is of the order of magnitude of 100 ps or 1 ns.

The outer electrodes 23, 24 can be used to control spin current and spin accumulation which can be can be detected using the inverse spin Hall effect and the spin valve effect respectively.

The magnitude of the spin current can be increased (or decreased) by an additional electric field generated by the outer electrodes 23, 24 by adding a drift velocity component to the diffusive spin current, $I_s$. Thus, an electric field can be used for amplifying a spin current.

The electric field introduces a drift current, $I_{e-D}$ (herein simply referred to as $I_D$), which is not spin polarized. However, in some embodiments, the drift current can be spin polarized. However, the electric field also changes the drift velocity of the spin-polarised charge-carriers. The electric field not only changes the spin current, but due to the modified spin current it also changes spin accumulation in the channel.

As explained earlier, the spin current may be injected into or generated in the channel 4 by (electrical) spin injection, by (optical) spin generation, by spin pumping, or by the spin-Seebeck effect.

Spin injection by spin generation can be achieved in the channel using an optically-active channel and a source of circularly-polarised light, such as a Ti:sapphire laser combined with a $\lambda/4$-wave plate to transform linearly-polarised laser light into circularly-polarised light. The channel comprises a direct-band gap semiconductor material, such as a GaAs, InSb or other suitable III-V semiconductor material or suitable II-VI semiconductor material. The direct-band gap semiconductor may comprise, for example, a binary or ternary alloy. The channel may include a heterostructure for forming a two-dimensional electron gas (2DEG) or a two-dimensional hole gas (2DHG). The circularly-polarised light has a suitable wavelength for optically generating charge carriers in the semiconductor.

Spin injection by spin pumping can be achieved using a ferromagnetic region in contact with a (non-ferromagnetic) channel. For example, the ferromagnetic electrode 17 can be used for spin pumping. The magnetization of the ferromagnetic region is periodically excited, for example by an external magnetic field and/or by a current in the ferromagnetic region, to precess around its equilibrium position at the Lamor frequency, $\omega_L$, which depend on the effective magnetic anisotropy, $K_{eff}$, and an applied constant magnetic field, $B_0$. A spin current is injected into the channel with a spin polarization along the equilibrium position of the magnetization in the ferromagnetic region. Reference is made to D. Fang et al.: "Spin-orbit-driven ferromagnetic resonance", Nature Nanotechnology, volume 6, page 413 (2011).

Spin injection by the spin Seebeck effect can be realised using a ferromagnetic electrode in contact with the channel. A Schottky barrier is formed between the ferromagnetic region and the channel. Spin injection is driven by generating a temperature gradient between the ferromagnetic electrode and the channel across the Schottky barrier. Reference is made to Breton et al.: "Thermal spin current from a ferromagnet to silicon by Seebeck spin tunnelling", Nature, volume 475, page 82 (2011) and to Walter et al.: "Seebeck effect in magnetic tunnel junctions", Nature Materials, volume 10, page 742 (2011).

*Device operation*

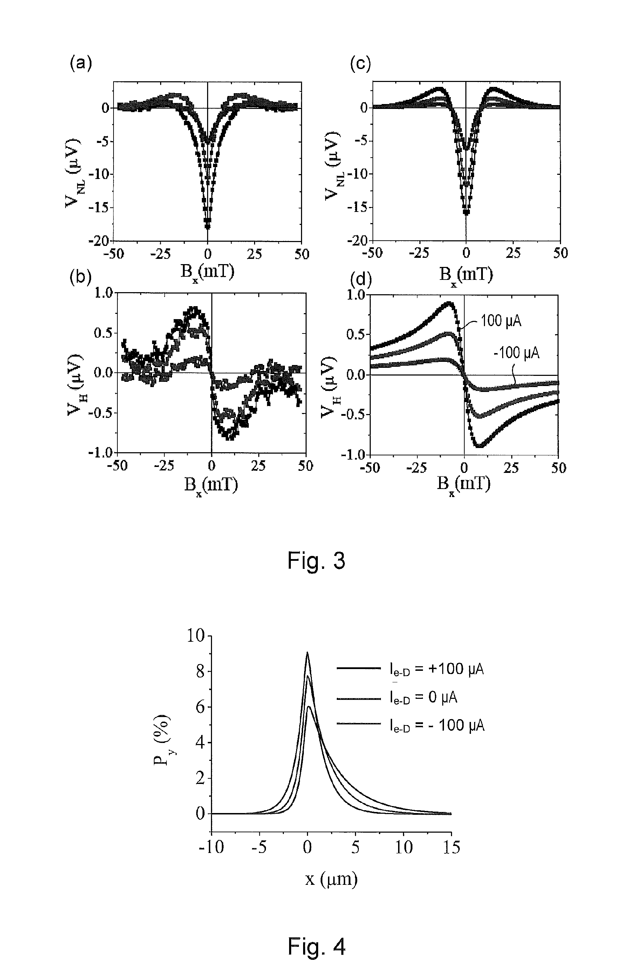

Referring to Figure 2 and Figures 3a, 3b, 3c and 3d, operation and measurement of the device 1 will be described.

A first current source 31 is used to drive a spin current, $I_{e\text{-}B}$ (herein simply referred to as $I_B$), through the first ferromagnetic electrode 17 (herein also referred to as the "injection electrode"). A second current source 32 is used to apply an additional bias between the two outer electrodes 23, 24 resulting in a drift current component $I_{e\text{-}D}$ (herein simply referred to as $I_D$) on both sides of the injection electrode 17. In this example, a spin current, $I_B$, is 300 $\mu$A and the additional bias, is set at -100 $\mu$A, 0 $\mu$A and + 100 $\mu$A.

A first voltmeter 33 can be used to measure a Hall voltage, $V_H$, across the channel 4, between the first pair of Hall probes 8. A second voltmeter 34 can be used to measure a non-local spin valve voltage along the channel 4, between second ferromagnetic electrode 17 (herein also referred to as the "detection electrode") and the second outer electrode 24.

A magnetic field source 35 in the form of a wire, lead or coil (not shown) and current source (not shown) can be used to generate a magnetic field 36 with a component which is orientated perpendicular to the polarization of the injected spins. As shown in Figure 2, the magnetic field 36 can be aligned along the length of the channel 4.

As shown in Figures 3a and 3b, both the spin polarization measured under the detection electrode 17 and the spin current measured by the inverse spin Hall effect depend on the applied bias between the outer electrodes 23, 24.

Without wishing to be bound by theory, the plots shown in Figures 3a and 3d can be explained by a shift of the injected spin polarization profile from the injection electrode 17 in a direction towards the detection electrode 17 in the case of $I_D$ = +100 $\mu$A. In the case of $I_D$ = -100 $\mu$A, the drift acts against diffusion on both sides of the injection electrode 17 which causes the spin polarization profile to decay more rapidly with position moving away from the injection point. Thus, the detected spin signals are enhanced for positive $I_D$ and suppressed for negative $I_D$.

Using the device 1, it is possible to modulate and even amplify an output spin signal by electrical means. The device is roughly analogous to bipolar transistor amplifier. For example, the spin current detected by the inverse spin Hall effect (or the spin polarization detected by the non-local spin valve effect) is a spin counterpart of collector current and the additional drift current, $I_D$, is reminiscent of a base current in the bipolar transistor. Although there a rough analogy between a charge-based bipolar transistor and the spin-based device herein described, it is important to note that there are significant and fundamental differences in the configuration of the devices and manner in which the devices operate. The spin-based device uses the property that spin is not conserved. By applying drift to electrons, the non-uniform spin-polarization profile along the channel can be shifted away or towards the spin detector which causes electrically-controlled modulation of the output signal. The approach of manipulating spin signals by electrically-induced drift of carriers can be used in not only semiconductors, but also metals.

*Theory*

Without wishing to be bound by theory, the spin dynamics in the channel can be modelled using spin drift-diffusion equations. If the polarization of the injected spin is in-plane and perpendicular to the channel (along the y-axis), then, for an applied in-plane hard-axis field $B_x$ (i.e. along the x-axis), the spins precess in the y - z plane and corresponding Hanle curves are obtained by solving:

$$\frac{ds_y(x)}{dt} + \frac{d}{dx}\left(-D\frac{ds_y(x)}{dx} + v_d(x)s_y(x)\right) + \frac{s_y(x)}{\tau_s} + g\mu_B B_x^{eff}s_z(x) = \dot{S}_0\delta(x)$$

$$\frac{ds_z(x)}{dt} + \frac{d}{dx}\left(-D\frac{ds_z(x)}{dx} + v_d(x)s_z(x)\right) + \frac{s_z(x)}{\tau_s} - g\mu_B B_x^{eff}s_y(x) = 0\,,$$

(A)

where the nuclear Overhauser field is included in the total effective field $B_x^{eff}$. Analogous equations apply for the Hanle curves for an out-of-plane field $B_z$. In equation A above, D is the diffusion constant, $v_d$ is the drift velocity, $\tau_s$ is the spin-dephasing time, g is the Landé factor of electrons (in this example, for GaAs), and $\mu_B$ is the Bohr magneton. The right-hand side of equation A for *the $s_y$* component describes the rate of spins parallel to the Fe magnetic easy-axis ($\hat{y}$-axis) injected from the Fe contact to the GaAs channel at x = 0.

The drift velocity can be different on the opposite sides (the right- and left-hand side in Figure 1) of the injection

electrode 17, $v_d(x) = \theta(x)\,v_d^R - \theta(x)\,v_d^L$, and is determined by the corresponding currents driven on either side of the injector 17. For a special case of $v_d^R = v_d^L$, the steady state spin density solving equation A is given by:

$$s_y(x) = \dot{S}_0 \int_0^\infty \frac{dt}{\sqrt{4\pi Dt}}\, \exp[(-x - v_d t)^2/4Dt]\, \exp[-t/\tau_s] \times \cos(g\mu_B B_x t/\hbar)$$

(B)

$s_z(x)$ is obtained by replacing cosine by sine in the above expression. Assuming the step-like discontinuity in the drift velocity at the injection point, which corresponds to geometry of the device 1, the solution of equation A above outside the injection point has the same functional form as equation B up to a normalizing factor. Outside the injection point, equation A above has the same form of a homogeneous differential equation for both the constant or step-like $v_d(x)$. The origin of the renormalization due to $v_d(x)$ with a sharp step at the injection point is that this form of $v_d(x)$ is equivalent to an additional source/sink term in the drift-diffusion equation at the injection point ($d\theta(x)/dx = \delta(x)$). As confirmed by numerical solution of the drift-diffusion equation, the two normalization factors for the right and left spin densities are obtained by matching the spin densities at the injection point and by requiring the same total integrated spin density as in the case of the constant drift velocity, i.e., $\int_{-\infty}^\infty dx\, s_y(x) = \tau_s \dot{S}_0/[1 + (\omega_B \tau_s)^2]$ and

$\int_{-\infty}^\infty dx\, s_z(x) = \tau_s \dot{S}_0 (\omega_B \tau_s)/[1 + (\omega_B \tau_s)^2]$. Note that the conservation of the integrated spin density is a consequence of the spatially independent spin-dephasing time and magnetic field in equation A.

The drift velocities corresponding to the measurements shown in Figures 3a and 3b are given by,

$v_d^R = I_D/enA$ and $v_d^L = (I_D + I_B)/enA$. Here $e$ is the electron charge, $n$ is the electron density in the channel, and $A$ is the cross-sectional area of the channel. At low temperatures (e.g. 4.2 K), the diffusion constant is given by the expression for a degenerate semiconductor, namely $D = \mu_e n\ /eg(E_F)$, where $\mu_e$ is the electron mobility and $g(E_F)$ is the density of states at the Fermi level in GaAs conduction band with effective mass $m^* = 0.067$. The mobility $\mu_e = 3.5\text{x}10^3\,\text{cm}^2\text{V}^{-1}\text{s}^{-1}$ and density $n = 1.1 \times 10^{17}\,\text{cm}^{-3}$, and the corresponding diffusion constant $D = 2.9 \times 10^{-3}\,\text{m}^2\text{s}^{-1}$ and drift velocities can be determined using ordinary Hall measurements in the GaAs channel. To extract the coefficients from the ordinary Hall data, it is assumed that $A = wt$ where the width of the channel $w = 20\,\mu\text{m}$ and the effective thickness of the conducting GaAs film $t = 270$ nm.

The spin-dephasing time $\tau_s = 1.65$ ns is obtained by matching the width of the theoretical and experimental Hanle curves. For higher accuracy, $\tau_s$ can be determined from measurements in the applied out-of-plane hard-axis field $B_z$, i.e., in the geometry where the Overhauser field is negligible. The remaining input parameter needed for obtaining the quantitative values of the theoretical non-local spin valve Hanle curves shown in Figure 3c is the overall normalization factor of the continuous solution of equation A (or equivalently the value of $\dot{S}_0$). This is obtained by matching the theoretical and experimental spin densities in GaAs underneath the detection electrode 18. The experimental value is inferred from the difference between the zero field non-local spin valve voltages at parallel and anti-parallel magnetization configurations of the injection and detection Fe electrodes considering:

$$\Delta V_{NL} = 2\eta \frac{P_{\text{Fe}} P_{\text{GaAs}} E_F}{2e}$$

(C)

Here $\eta = 0.5$ is the spin transmission efficiency of the interface, $P_{Fe} = 0.42$ is the polarization of the Fe electrode, and $P_{GaAs} = s_y(x_d)/n$ is the electron spin polarization in GaAs underneath the Fe detection electrode 18 (i.e. $x = x_d$).

The inverse spin Hall effect is proportional to the z-component of the spin-current given by $j_z^s(x) = -D\vec{\nabla}s_z(x) + v_d(x)s_z(x)$. Since $j_z^s(x)$ depends on the spatial coordinate, the response function

$F_{cross}(x)$ of the finite-size Hall cross is also considered when interpreting measurements. A numerical evaluation of $F_{cross}(x)$ is performed for the device geometry using conformal mapping theory which is hereinafter described. The measured inverse spin Hall effect signal is then proportional to $J_z^s = \int_{-\infty}^{\infty} dx j_z^s(x) F_{cross}(x) / \int_{-\infty}^{\infty} dx F_{cross}(x)$. The spin current and the iSHE voltage are related by, $V_H = ew\alpha J_z^{\ s}/\sigma$, where $\alpha$ is the spin Hall angle and $\sigma = ne\mu_e$ is the electrical conductivity of the GaAs channel. The theoretical $V_H$ plotted in Figure 3d is obtained by taking $\alpha = 1.5 \times 10^{-3}$ which is a value consistent with the estimates of the skew-scattering Hall angle for the disordered weakly spin-orbit coupled GaAs channel (hereinafter described). The calculated plots shown in Figures 3c and 3d are in agreement with the measured plots shown in Figures 3a and 3b, thus demonstrating agreement between the measured and calculated non-local spin valve and iSHE voltages. The theory successfully describes the dependence of the measured spin signals on both the applied magnetic field and on the applied electrical drift current.

Further details of the underlying principles and equations used in the model hereinbefore described will now be described:

Spin drift-diffusion equation

A drift-diffusion equation in one dimension can be defined as follows:

$$\frac{dS_i(x,t)}{dt} + \vec{\nabla} \cdot \left(-D\vec{\nabla}S_i(x,t) + \vec{v}_d(x)S_i(x,t)\right) + \frac{S_i(x,t)}{\tau_s} + \gamma\epsilon_{ijk}B_jS_k(x,t) = G_i(x,t)$$

$$(1)$$

where D is the diffusion constant, $v_d$ is the drift velocity, $\tau_s$ is the spin-dephasing time and $\gamma$ is the gyromagnetic ratio. $\vec{G}$ is the injection rate. Using these relations to rescale relevant quantities

$$x^* = \frac{x}{L_s}, \; t^* = \frac{t}{\tau_s}, \; \vec{S}^* = \frac{\vec{S}}{G_0\tau_s}, \; \vec{G}^* = \frac{\vec{G}}{G_0}, \; \vec{B}^* = \gamma\tau_s\vec{B}, \; \vec{v}_d^{\;*} = \frac{\tau_s}{L_s}\vec{v}_d, \; \text{and } L_s^2 = D\tau_S$$ the equation can be reduced to:

$$\frac{dS^*_i(x^*,t^*)}{dt^*} + \vec{\nabla} \cdot \left(-\vec{\nabla}S_i^* + \vec{v}_d^*S_i^*\right) + S_i^* + \epsilon_{ijk}B_j^*S_k^* = \frac{G_i^*}{G_0}$$

$$(2)$$

- Zero field case -

The zero magnetic field can be solved analytically in a straight forward way. Following the experimental set-up let us assume that $\vec{G}(x) = G_0\delta(x)\hat{z}$, and that there is no magnetic field. Then, in the steady-state case (when the time derivative is zero):

$$-S_y^{*\,\prime\prime}(x) + (v_d^*(x)S_y^*(x))' + S_y^*(x) = \delta(x)$$

$$(3)$$

Here the equation has been written for the $y$-component of S only since without magnetic field each component is uncoupled and since we are injecting in the $y$-direction only $S_y$ is of interest. Assuming that $v_d$ is constant:

$$-S_y''(x) + v_d S_y'(x) + S_y(x) = \delta(x) \tag{4}$$

Note that $v_d$ refers to the scaled drift velocity as prescribed before. It is also the only free parameter in this differential equation. The solution is $S(x) = \frac{1}{2\omega} e^{\alpha x} e^{-\omega|x|}$ where $\alpha = \frac{v_d}{2}$ and $\omega^2 = 1 + \alpha^2$.

Next, the case is considered that $v_d$ is given by a discontinuous step function, such that $v_d(x) = v_d^L \theta(-x) + v_d^R \theta(x)$. The solution is given by:

$$S(x) = \frac{1}{(\omega^R + \omega^L + \alpha^R - \alpha^L)} [e^{(\alpha^L + \omega^L)x} \theta(-x) + e^{(\alpha^R - \omega^R)x} \theta(x)],$$

$$\text{where } \alpha^L = \frac{v_d^L}{2}, \qquad \alpha^R = \frac{v_d^R}{2}, (\omega^L)^2 = 1 + (\alpha^L)^2, \qquad (\omega^R)^2 = 1 + (\alpha^R)^2. \tag{5}$$

- Non-zero field case -

For the case of finite magnetic field it is more straight forward and transparent to proceed in a simple numerical way. For the case of constant drift velocity the solution has the form:

$$S_y(x) = \dot{S}_0 \int_0^\infty \frac{1}{\sqrt{4\pi Dt}} \exp[(-x - v_d t)^2 / 4Dt] \exp[-t/\tau_s] \times \cos(g\mu_B B_x t/\hbar) \tag{6}$$

with the solution for $S_z$ obtained by replacing cosine by sine in the above expression. A sharp step-like form of $v_d(x)$ is equivalent to a source/sink term in the drift-diffusion equation, since a discontinuous drift velocity will tend to accumulate spin at the discontinuity. Within a constant $\tau_s$ approximation, the full steady-state solution of the drift-diffusion equation can be shown to be normalized to $\tau_s S_0/(1 + (\omega_B \tau_s)^2)$ for the y-component and $\tau_s S_0(\omega_B \tau_s)/(1 + (\omega_B \tau_s)^2)$ for the z-component. Hence, the solution for $S_y(x)$ and $S_z(x)$ assuming a step-function behaviour of $v_d(x)$ is obtained by Equation 6 above for constant $v_d$ on the left and the right of the drift velocity discontinuity with Equation 6 multiplied by appropriate constant factors on the left and on the right to make $S_y(x)$ and $S_z(x)$ continuous and normalized correctly.

In Figure 4, $S_y(x)$ for the situation where the additional drift current $I_D$ is +100 μA, 0, -100 μA and the bias current through the injection electrode $I_B$ = 300 μA. The spin-current generated by this spin accumulation profile is given by

$$j_i \equiv -D\vec{\nabla} s_i(\vec{r}) + v_d(\vec{r}) s_i(\vec{r}) \tag{7}$$

Hall effect

The conduction electrons can be modelled through the following effective Hamiltonian, namely:

$$H = \frac{\hbar^2 k^2}{2m} + V_{\text{dis}}(\mathbf{r}) + \lambda^* \boldsymbol{\sigma} \cdot (\mathbf{k} \times \nabla V_{\text{dis}}(\mathbf{r}))$$

$$(8)$$

where *the* $m = 0.067\, m_e$ and $V_{dis}$ is the disorder potential modelled by uncorrelated delta scatterers of strength $V_0$ and density $n_i$. For GaAs $\lambda^* = 5.3$ Å. The Hall effect signal can be understood within the theory of the anomalous Hall effect (AHE). The contributions to the AHE in SO coupled systems with non-zero polarization can be classified in two types: the first type arises from the SO coupled quasiparticles interacting with the spin-independent disorder and the electric field, and the second type arises from the non-SO coupled part of the quasiparticles scattering from the SO coupled disorder potential. The contributions of the first type do not dominate the physics of this weakly spin-orbit coupled system, and is therefore not included in Equation 8 above.

The contributions of the second type, i.e. from interactions with the SO coupled part of the disorder are due to the anisotropic scattering, the so called extrinsic skew-scattering, and is obtained within the second Born approximation treatment of the collision integral in the semi-classical linear transport theory:

$$|\sigma_{\text{xy}}|^{\text{skew}} = \frac{2\pi e^2 \lambda^*}{\hbar^2} V_0 \tau n^2$$

$$(9)$$

Using the relation for mobility $\mu = e\tau/m$ and the relation between $n_i$, $V_0$, and $\tau$, $\hbar/\tau = n_i\, V_0^2 m/\hbar^2$, the extrinsic skew-scattering contribution to the iSHE angle due to a pure spin-current, $\alpha \equiv \rho_{xy}/\rho_{xx} \approx \sigma_{xy}/\sigma_{xx}$, can be written as:

$$\alpha^{\text{skew}} = 2.44 \times 10^{-4} \frac{\lambda^*[\text{Å}^2] n_{2\text{D}}[10^{11}\text{cm}^{-2}]}{\sqrt{\mu[10^3\text{cm}^2/\text{Vs}] n_{2\text{D}-i}[10^{11}\text{cm}^{-2}]}}$$
$$\sim 3.8 \times 10^{-3},$$

$$(10)$$

where $n_{2D} = n_t = 3.0 \times 10^{12}$ cm$^{-2}$, $t = 270$ nm (i.e. the thickness of the GaAs film thickness), n = 1.1 $\times$ 10$^{12}$ cm$^{-2}$, $\mu =$ 3.5 $\times$ 10$^3$ cm$^2$V$^{-1}$s$^{-1}$, and $n_{2D\text{-}i} \approx 3.0 \times 10^{12}$ cm$^{-2}$.

Hall response function

When dealing with non-uniform currents, it is non-trivial to relate the measured Hall voltage signal with the Hall angle or Hall coefficient of the system. In geometries where the Hall probe width and the channel width are of similar magnitude the current density near the cross can contribute to the Hall signal more significantly and one must solve the full equations relating the current density and the fields. For the case where anomalous Hall effect is considered in addition to the normal Hall effect, current can be expressed as:

$$\vec{j}(x,y) = \rho^{-1}(-\vec{\nabla}V(x,y) + \vec{j}(x,y) \times [R_0\vec{B}(x,y) + 4\pi R_s\vec{M}(x,y)]$$

$$(11)$$

where $\rho$ is the diagonal electrical resistivity of the layer, $\vec{B}$ and $\vec{M}$ are the local magnetic induction and magnetization, and R0 and Rs are the normal and anomalous Hall coefficients. Here, a thin film geometry is assumed such that $j_z = 0$

and the problem is reduced to two dimensions.

Maxwell equations for a static magnetic field are solved, namely:

$$\nabla^2 V = 0 \ \text{ and } \ \vec{\nabla} \cdot \vec{j} = 0 \tag{12}$$

with the boundary condition that the current is zero at the insulating cross boundaries, i.e. $\ \vec{j} \cdot \hat{n} = 0 \ $ at the boundaries.

A similar procedure is followed as that taken in A. Thiaville et al.: "Measurement of the stray field emanating from magnetic force microscope tips by Hall effect microsensors". Journal of Applied Physics, volume 82, page 3182 (1997) and J. Wunderlich et al.: "Influence of geometry on domain wall propagation in a mesoscopic wire", IEEE Transactions on Magnetics, volume 37, page 2104 (2001). Taking $\beta = \rho^{-1}[R_0 B(x,y) + 4\pi R_s M_\perp (x,y)]$, equations 11 and 12 above reduce to:

$$(1+\beta^2))\nabla^2 V + (1-\beta^2)\left(\frac{\partial\beta}{\partial x}\frac{\partial V}{\partial y} - \frac{\partial\beta}{\partial y}\frac{\partial V}{\partial x}\right) - 2\beta\left(\frac{\partial\beta}{\partial x}\frac{\partial V}{\partial x} + \frac{\partial\beta}{\partial y}\frac{\partial V}{\partial y}\right) = 0 \tag{13}$$

and at the boundary condition to $\nabla_\perp V = -\beta\nabla_\parallel V$. Since $\beta$ tends to be small in most systems of interest, the problem can be treated perturbatively, $V = V_0 + V_1 + ...$ whose first two components solve:

$$\nabla^2 V_0 = 0 \tag{14}$$

with $\partial V_0/\partial n = 0$ at the boundaries and

$$\nabla V_1 = \frac{\partial\beta}{\partial y}\frac{\partial V_0}{\partial x} - \frac{\partial\beta}{\partial x}\frac{\partial V_0}{\partial y} \tag{15}$$

with $\nabla_\perp V_1 = -\beta\nabla_\parallel V_1$ at the boundaries. Solving these equations for the case of a delta-like magnetic field at position ($x$, $y$) yields the Hall response function which can then be convoluted with the non-constant magnetic field or magnetization to obtain the total Hall signal expected.

In this device described earlier, the response to a pure spin-current which can be considered as two fully spin polarised charge currents with opposite polarities and direction. This allows the result shown here to be used, only ignoring the small fraction contributing from the polarised charge current on the left of the injection point far away, relative to the spin-diffusion length, from the detecting Hall bar.

-Solution of $V_0$-

The solution of $V_0$ for the Hall cross bar geometry can be done using the conformal mapping technique. In here one uses the fact that for any analytical function $f(z) = u(x, y) + iv(x, y)$ in the complex z-plane, the conjugate functions $u$ and $v$ solve the Laplace equation. Then, the problem reduces to finding the analytical function that solves the boundary conditions of the problem. To do so one can do a conformal mapping of the region of interest in the z-plane to a much easier configuration in another complex plane, e.g. parallel plate. The conformal mapping preserves the boundary conditions and the solution in the z-plane can be obtained by mapping backwards the trivial solution in the complex plane.

For the case of the Hall cross, or any polygon structure for that matter, one uses the Swartz-Christoffen transformation. We impose the boundary condition for $f(z) = u(x, y) + iv(x, y)$ such that $v$ is equal to $\pm\pi$ at the boundary edges along the channel. The Swartz-Christoffen transformation transforms any interior region of a polygon (even ones with open boundaries where the vertex is at infinity) onto the upper half of the complex plane with the vortices mapped to points in the real axis. For the present configuration the map reads:

$$\frac{dz}{dw} = Ci\frac{\sqrt{z^2 - a^2}}{z^2 - b^2}$$

(16)

where $a, b, C$ are constants adjusted such that the vortices map correctly to the right places. This maps the problem to a system where the potential is $\pm\pi$ on the real axis which can the be mapped simply via a second transformation:

$$\xi = \log\left(\frac{w - 1}{w + 1}\right) - i\pi$$

(17)

which is simply the solution of a parallel plate capacitor. Depending on the geometry some fraction of the current avoids the central region of the cross bar.

-Solution of the Hall response function: of $V_1$ for a Dirac $\delta$-function magnetic field-Since the equations that being solved retain, to first order, the principle of superposition the Hall response function due to a delta function magnetic field can be solved.

The Hall response function is found (see Thiaville et al. *ibid.*) to be:

$$F_{cross}(x, y) = \frac{\pi}{2}\frac{\mathrm{Im}\sqrt{w^2 - b^2}}{|w^2 - a^2|}$$

(18)

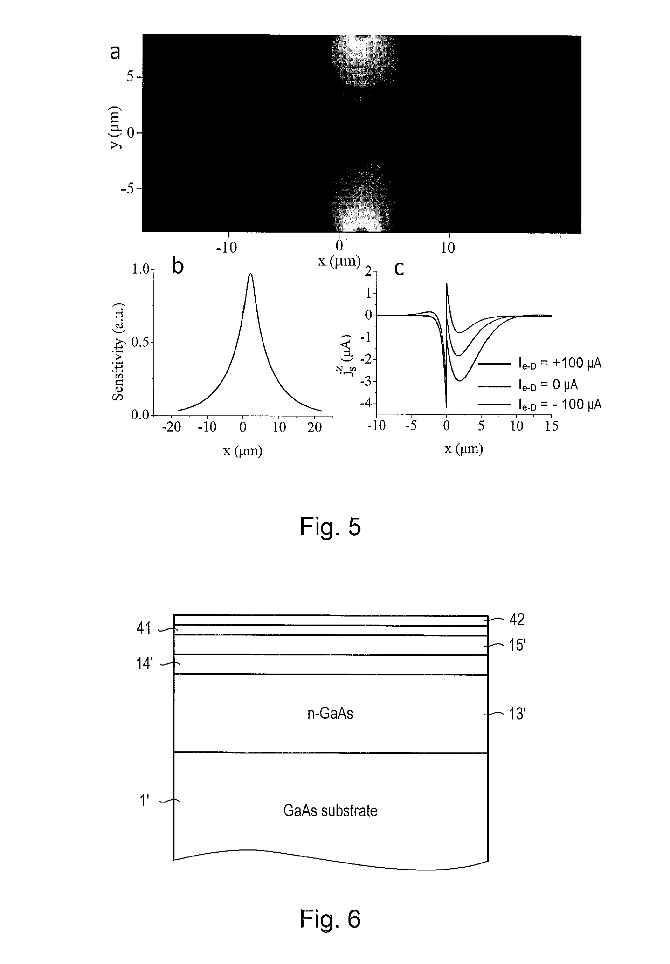

The above response function is normalized to $2\pi$. The response function for the device described earlier is shown in Figure 5a. In realistic situations, there is no current within about 100nm of the edge and so it possible to exclude the sharp part of the response function near these edges. Since only spin accumulation is being considered in one dimension, this response function can be averaged in the y-direction, as shown in Figure 5b. Solving for the spin-current from the drift-diffusion equations in one dimension, shown in Figure 5c, using Equation 7 above, the result can be convoluted with the response function integrated along the y-direction to obtain measured spin-current $J_z^s = \int_{-\infty}^{\infty} dx\, j_z^s(x) F_{cross}(x) / \int_{-\infty}^{\infty} dx\, F_{cross}(x)$ which is related to the inverse spin Hall effect (iSHE) voltage by $V_H = e\omega\alpha J_z^2/\sigma$ .

*Device fabrication*

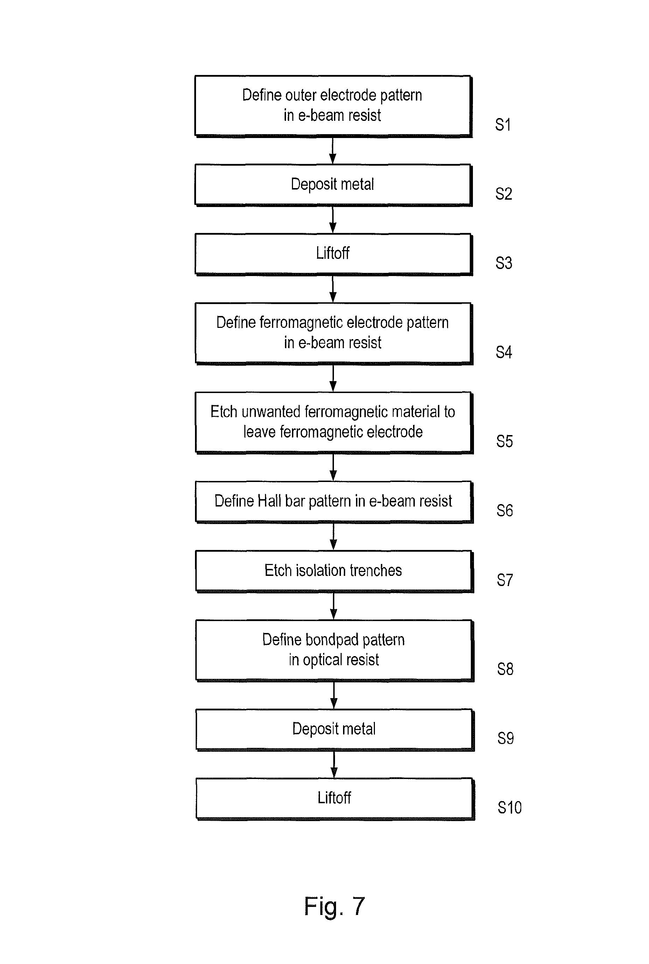

Referring to Figures 6 and 7, a method of fabricating the device shown in Figure 1 will now be described.

Figure 6 shows a heterostructure 40 grown by molecular beam epitaxy. The heterostructure 40 is grown in chamber (not shown) without breaking ultra high vacuum conditions during the whole growth process.

Layers are deposited on an undoped GaAs substrate 1'. The layers include a layer 13' of low Si-doped GaAs ($5\times10^{16}$ cm$^{-3}$) having a thickness of 250 nm, followed by a layer 14' of GaAs with graded doping having a thickness of 150 nm and layer 15' or highly Si-doped GaAs ($5\times10^{18}$ cm$^{-3}$) having a thickness of 15 nm. The doping profile yields a narrow tunnel Schottky barrier between GaAs and Fe favourable for spin injection/detection. The growth temperature of GaAs was 580°C. The sample was then cooled to 0°C for the growth of a 2 nm Fe layer 41. A reflection high energy electron diffraction pattern observed after the Fe deposition confirmed the epitaxial growth of cubic Fe. The Fe film 41 was capped by a 2 nm A1 layer 42 to prevent Fe oxidation.

Electron-beam lithography and reactive ion etching are used to pattern the lateral GaAs channel with the Hall crosses and magnetic electrodes, as follows.

The first and second electrodes 23, 24 (Figure 1) are defined by electron beam lithography, Ti/Au evaporation and lift off (steps S1, S2 & S3).

The ferromagnetic electrodes 17, 18 (Figure 1) are defined by forming an etch mask and selective etching the Fe/Al double layer (steps S4 & S5).

The Hall bar 3 is defined by forming etch mask and etching isolation trenches by reactive ion etching (steps S6 & S7).

Bond pads (not shown) and air bridges (not shown) to the electrodes 17, 18, 23, 24 are formed by electron beam lithography, Ti/Au evaporation and liftoff (steps S8, S9 & S10).

It will be appreciated that many modifications may be made to the embodiments hereinbefore described.

The ferromagnetic electrode may comprise other magnetic materials, such as an alloy of nickel and iron (also called a "permalloy" alloy) or a Heusler alloy which typically has a formula $X_2YZ$ where Y is a magnetic element such as manganese or iron.

Spins in the channel can be manipulated via Hanle spin precession induced by an applied magnetic field.

The channel may have a width of at least 100 nm, at least 200 nm or at least 1 $\mu$m. The channel may have a width no more than 50 $\mu$m, no more than 20 $\mu$m, no more than 10 $\mu$m, no more than 5 $\mu$m, no more than 2 $\mu$m or no more than 1 $\mu$m.

The channel may have a thickness no more than 100 nm, no more than 50 nm, no more than 20 nm or no more than 10 nm. For example, the channel may take the form of a thin (e.g. less than 10 nm or 5 nm) layer, such a 2-dimensional electron gas.

The outer electrodes can be separated by less than 200 $\mu$m. For example, the outer electrodes can be separated by no more than 20 $\mu$m, no more than 5 $\mu$m, no more than 2 $\mu$m and even no more than 1 $\mu$m. The injector electrode (or other form of spin injector) may be separated from another electrode (such as a spin accumulation detector electrode) by no more than 10 $\mu$m, no more than 5 $\mu$m, no more than 2 $\mu$m or no more than 1 $\mu$m. The injector electrode may be separated from a spin current detector by no more than 10 $\mu$m, no more than 5 $\mu$m, no more than 2 $\mu$m or no more than 1 $\mu$m.

Spin may be injected at least 50 nm, 100 nm, at least 200 nm or at least 500 nm from the outer electrodes. For example, if an injector electrode is used, the injector electrode may be separated from the outer electrodes by at least 50 nm, 100 nm, at least 200 $\mu$m or at least 500 nm. Spin may be injected at least 1 $\mu$m, at least 2 $\mu$m, at least 5 $\mu$m or at least 10 $\mu$m from the outer electrodes. For example, the injector electrode may be separated from the outer electrodes by at least 1 $\mu$m, at least 2 $\mu$m, at least 5 $\mu$m or at least 10 $\mu$m. Spin may not be injected at and/or outside the outer electrodes. For example, the injector electrode may not be placed at the same point as an outer electrode and/or the same electrode may not be used for both spin injection and field generation.

The device may operate at a temperature at or below 300 K. The device may operate at or below 77 K. The apparatus may include a refrigerator, such as a cryostat, and/or other cooling device, such as a thermoelectric cooler, for cooling the device below 300 K and/or below 77 K.

The easy axis (axes) of ferromagnetic electrode(s) need not be arranged perpendicular to the length of the channel. The easy axis (axes) of ferromagnetic electrode(s) need not be arranged in plane of the layer. For example, an easy axis may be arranged perpendicular to the plane of the electrode.

The ferromagnetic electrodes need not be deposited epitaxially, but can be deposited, for example, by sputtering or thermal evaporation.

The electrodes can be thicker or thinner and can be formed from other suitable materials.

The device may be fabricated using other fabrication techniques, such as wet etching.

**Claims**

1. A spin-based device comprising:

   a channel (4);
   first and second electrodes (23, 24) configured, in response to a bias configuration, to generate an electric field along the channel; and
   a spin injector (17) configured to inject a spin-polarised current into the channel at a point between the first and second electrodes.

2. A device according to claim 1, further comprising:

   a spin current detector (9) configured to detect a spin current at a second, different position between the first and second electrodes.

3. A device according to claim 2, wherein the spin current detector (9) comprises:

   at least one Hall probe (9) disposed between the spin injector (17) and one of the first and second electrodes (23, 24).

4. A device according to any preceding claim, further comprising:

   a spin accumulation detector (18) configured to detect spin accumulation at a third position between the first and second electrodes.

5. A device according to claim 4, wherein the spin detector (18) comprises:

   a ferromagnetic electrode (18) disposed between the spin injector (17) and the second electrode (24).

6. A device according to claim 5, further comprising:

   a voltmeter (34) arranged to measure a bias between the ferromagnetic electrode and the second electrode (24).

7. A device according to any preceding claim, wherein the spin injector (17) comprises a ferromagnetic electrode.

8. A device according to claim 7, wherein the ferromagnetic electrode (17) comprises iron, nickel and/or cobalt.

9. A device according to claim 7 or 8, wherein the ferromagnetic electrode (17) comprises a Heusler alloy.

10. A device according to any preceding claim, wherein the spin injector comprises a light source directed at the channel (4).

11. A device according to any preceding claim, wherein the spin injector comprises a ferromagnetic region in contact with the channel for injecting spin into the channel using spin pumping.

12. A device according to any preceding claim, wherein the spin injector comprises a ferromagnetic region for injecting spin using spin Seebeck effect.

13. A device according to any one of claims 1 to 12, wherein the channel (4) comprises a semiconductor material.

14. A device according to claim 13, wherein the semiconductor material is gallium arsenide.

15. A device according to claim 13 or 14, wherein the channel (4) is doped with acceptors or donors to an average concentration of no more than $1 \times 10^{18}$ cm$^{-3}$.

16. A device according to any one of claims 1 to 11, wherein the channel (4) comprises a metallic material.

17. Apparatus comprising:

   a spin-based device (1) according to any preceding claim;
   a bias source (32) configured to apply a bias between the first and second electrodes (23, 24).

18. Apparatus according to claim 17, further comprising:

   a bias source (31) configured to cause the spin injector to inject spin into the channel (4).

**19.** A method of operating a spin-based device comprising:

generating an electric field along a channel (4);
injecting spin into the channel.

**20.** A method according to claim 19, further comprising:

detecting spin current in the channel.

**21.** A method according to claim 19 or 20, further comprising:

detecting spin accumulation in the channel.

**22.** A method according to any one of claims 19 to 21, wherein generating the electric field comprises applying a bias between first and second electrodes spaced apart along the channel.

Fig. 1

Fig. 1a

Fig. 2

EP 2 610 913 A1

Fig. 3

Fig. 4

17

Fig. 5

Fig. 6

| | |
|---|---|
| Define outer electrode pattern in e-beam resist | S1 |
| ↓ | |
| Deposit metal | S2 |
| ↓ | |
| Liftoff | S3 |
| ↓ | |
| Define ferromagnetic electrode pattern in e-beam resist | S4 |
| ↓ | |
| Etch unwanted ferromagnetic material to leave ferromagnetic electrode | S5 |
| ↓ | |
| Define Hall bar pattern in e-beam resist | S6 |
| ↓ | |
| Etch isolation trenches | S7 |
| ↓ | |
| Define bondpad pattern in optical resist | S8 |
| ↓ | |
| Deposit metal | S9 |
| ↓ | |
| Liftoff | S10 |

Fig. 7

Europäisches
Patentamt

European
Patent Office

Office européen
des brevets

# EUROPEAN SEARCH REPORT

Application Number

EP 11 19 6194

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | EP 2 190 022 A1 (HITACHI LTD [JP]) 26 May 2010 (2010-05-26) | 1-3,10, 13-15, 17-20,22 | INV. H01L29/66 H01L43/06 |
| Y | * the whole document * | 4-6,16, 21 | |
| X | EP 1 942 527 A1 (KOREA INST SCI & TECH [KR]) 9 July 2008 (2008-07-09) <br><br> * abstract; figure 3 * | 1,7-9, 11-15, 17-19,22 | |
| Y | US 2009/121267 A1 (HONG KI-HA [KR] ET AL) 14 May 2009 (2009-05-14) * abstract * | 16 | |
| Y | US 2011/042648 A1 (KOO HYUN CHEOL [KR] ET AL) 24 February 2011 (2011-02-24) * abstract; figure 1 * | 4-6,21 | |

|  | TECHNICAL FIELDS SEARCHED (IPC) |
|---|---|
|  | H01L |

The present search report has been drawn up for all claims

| Place of search | Date of completion of the search | Examiner |
|---|---|---|
| The Hague | 14 May 2012 | Baillet, Bernard |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

**ANNEX TO THE EUROPEAN SEARCH REPORT
ON EUROPEAN PATENT APPLICATION NO.**                    EP 11 19 6194

This annex lists the patent family members relating to the patent documents cited in the above-mentioned European search report.
The members are as contained in the European Patent Office EDP file on
The European Patent Office is in no way liable for these particulars which are merely given for the purpose of information.

14-05-2012

| Patent document cited in search report | | Publication date | Patent family member(s) | | Publication date |
|---|---|---|---|---|---|
| EP 2190022 | A1 | 26-05-2010 | CN | 101738374 A | 16-06-2010 |
| | | | EP | 2190022 A1 | 26-05-2010 |
| | | | JP | 2010122211 A | 03-06-2010 |
| | | | KR | 20100056960 A | 28-05-2010 |
| | | | TW | 201022650 A | 16-06-2010 |
| | | | US | 2010123133 A1 | 20-05-2010 |
| EP 1942527 | A1 | 09-07-2008 | EP | 1942527 A1 | 09-07-2008 |
| | | | JP | 2008166689 A | 17-07-2008 |
| | | | KR | 100832583 B1 | 27-05-2008 |
| | | | US | 2008169492 A1 | 17-07-2008 |
| | | | WO | 2008082051 A1 | 10-07-2008 |
| US 2009121267 | A1 | 14-05-2009 | CN | 101855727 A | 06-10-2010 |
| | | | EP | 2208231 A2 | 21-07-2010 |
| | | | JP | 2011503867 A | 27-01-2011 |
| | | | KR | 20090048311 A | 13-05-2009 |
| | | | US | 2009121267 A1 | 14-05-2009 |
| | | | US | 2010271112 A1 | 28-10-2010 |
| US 2011042648 | A1 | 24-02-2011 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2190022 A

**Non-patent literature cited in the description**

- **S. DATTA ; B. DAS.** Electronic analog of the electrooptic modulator. *Applied Physics Letters,* 1990, vol. 56, 665-667
- **B. HUANG ; D. MONSMA ; I. APPELBAUM.** Experimental realization of a silicon spin field-effect transistor. *Applied Physics Letters,* 2007, vol. 91, 072501
- **D. FANG et al.** Spin-orbit-driven ferromagnetic resonance. *Nature Nanotechnology,* 2011, vol. 6, 413
- **BRETON et al.** Thermal spin current from a ferromagnet to silicon by Seebeck spin tunnelling. *Nature,* 2011, vol. 475, 82
- **WALTER et al.** Seebeck effect in magnetic tunnel junctions. *Nature Materials,* 2011, vol. 10, 742
- **A. THIAVILLE et al.** Measurement of the stray field emanating from magnetic force microscope tips by Hall effect microsensors. *Journal of Applied Physics,* 1997, vol. 82, 3182
- **J. WUNDERLICH et al.** Influence of geometry on domain wall propagation in a mesoscopic wire. *IEEE Transactions on Magnetics,* 2001, vol. 37, 2104